# EUROPÄISCHE PATENTSCHRIFT

(11) **EP 0 628 832 B1**
(45) Veröffentlichungstag und Bekanntmachung des Hinweises auf die Patenterteilung: **05.12.2001**
(21) Anmeldenummer: 94201561.1
(22) Anmeldetag: 01.06.1994
(51) Int. Cl.: G01R 31/318, G06F 11/26, G01R 31/28

(54) **Integrierte Schaltung mit Registerstufen**
Integrated circuit with register stages
Circuit intégré comportant des étages de registres

(30) Priorität: 03.06.1993 DE 4318422
(43) Veröffentlichungstag der Anmeldung: 14.12.1994
(73) Patentinhaber: Philips Corporate Intellectual Property GmbH, 52064 Aachen (DE); Koninklijke Philips Electronics N.V., 5621 BA Eindhoven (NL)
(72) Erfinder: Scheuermann, Kurt, D-20097 Hamburg (DE); Ebert, Harald, D-20097 Hamburg (DE)
(74) Vertreter: Volmer, Georg, Dipl.-Ing.

(56) Entgegenhaltungen:
- EP-A- 0 136 461
- EP-A- 0 358 376
- GB-A- 2 193 330

## Beschreibung

Die Erfindung betrifft eine integrierte Schaltung mit mehreren taktgesteuerten Registerstufen, von denen jede wenigstens einen Takteingang, einen Dateneingang und einen Ausgang aufweist und bei der einen Flanke von dem Takteingang zugeführten Impulsen ein dem Dateneingang zugeführtes Signal speichert und am Ausgang abgibt.

Integrierte Schaltungen müssen nach der Herstellung auf ihre Funktionsfähigkeit geprüft werden. Dies ist bei rein kombinatorisch aufgebauten Schaltungen nicht allzu schwierig, selbst wenn diese umfangreich sind, da die Anzahl der möglichen Signalkombinationen auch bei einer Vielzahl von Eingängen begrenzt ist. Dies trifft bei sequentiellen Schaltungen jedoch nicht mehr zu, da diese speichernde Elemente enthalten und somit die Signale an den Ausgängen nicht nur von dem momentan an die Eingänge angelegten Testmuster, sondern auch von vorhergehenden Zuständen abhängen. Dadurch wird die Anzahl der Signalkombinationen in den Testmustern so groß, daß ein vollständiger Test der integrierten Schaltung derart viel Zeit in Anspruch nimmt, daß er nicht mehr wirtschaftlich möglich ist. Aus diesem Grunde sind in der Vergangenheit verschiedene Testverfahren entwickelt worden, um auch sequentielle logische Schaltungen möglichst weitgehend bzw. vollständig prüfen zu können. Die bekanntesten Verfahren sind die sogenannten Boundary Scan-Verfahren, die darauf beruhen, daß alle speichernden Elemente wie Registerstufen in einen besonderen Testzustand eingestellt werden können, in dem diese Stufen alle in Form eines Schieberegisters in Reihe geschaltet sind. Dadurch können seriell Testmuster in die Registerstufen eingeschrieben werden, die direkt wieder ausgelesen werden können, um die Funktion der Registerstufen selbst zu prüfen, und andererseits können Testmuster in die Registerstufen eingeschrieben werden, mit denen die an die Registerstufen angeschlossenen kombinatorischen Teile der gesamten integrierten Schaltung angesteuert werden, und die von diesen kombinatorischen Schaltungsteilen gelieferten Signalergebnisse werden wieder von Registerstufen übernommen, damit sie danach beispielsweise seriell ausgegeben werden können.

Derartige Verfahren sind beispielsweise in der Zeitschrift "Elektronik" Nr. 21 vom 14.10.1988, Seiten 161 bis 166 beschrieben. Darin wird u.a. auch eine Version erläutert, bei der jedem Registerelement eine sogenannte Latch-Zelle nachgeschaltet ist, und es ist eine zusätzliche Steuerleitung vorgesehen, um die gesamte Schaltung zwischen Testbetrieb und Normalbetrieb umzuschalten.

Häufig sind in einer integrierten Schaltung zwei oder mehr Gruppen von Registern vorhanden, die über getrennte Taktleitungen betrieben werden, d.h. es gibt innerhalb der integrierten Schaltung mehrere Taktsysteme. Für den Testbetrieb werden jedoch alle Registerstufen in einer Kette zusammengeschaltet und mit dem gleichen Taktsignal betrieben. Dadurch kann der Fall auftreten, daß die wirksame Flanke eines Taktimpulses für zwei unmittelbar hintereinander geschaltete Registerstufen größere Unterschiede in der Verzögerung aufweist als die Datenverbindung der beiden Registerstufen, so daß ein einwandfreier Schieberegisterbetrieb zumindest nicht ohne weiteres möglich ist.

Um diese Schwierigkeiten zu vermeiden, ist beispielsweise aus der genannten Druckschrift bekannt, die sogenannte LSSD-Methode oder pegelempfindliche Entwurfsmethode zu verwenden. Darin sind Registerstufen nicht mehr taktflankegesteuert, sondern es werden zwei Taktphasen mit nicht überlappenden Impulsen verwendet, und jede Registerstufe enthält dann zwei Abschnitte, die nacheinander wirksam werden. Dieses Prinzip hat jedoch den Nachteil, dass derartige Registerstufen im Normalbetrieb langsamer arbeiten als taktflankengesteuerte Registerstufen.

In der US-PS 4,277,699 ist daher eine derartige taktphasengesteuerte Registerstufe beschrieben, die von einem Betrieb mit zwei Taktphasen für die Prüfung auf einen gewissen flankengesteuerten Betrieb im Normalfall umgeschaltet werden kann. Dabei werden jedoch insgesamt drei Taktsignale verwendet, und die Schaltung ist kompliziert aufgebaut und arbeitet nicht sehr schnell. Dies gilt auch für eine Weiterentwicklung einer derartigen Registerstufe, die in der US 4,554,466 beschrieben ist.

In der EP 0 358 376 ist eine integrierte Testschaltung (Test-Zelle) offenbart, die innerhalb einer integrierten Schaltung das sogenannte Boundary Scan Testverfahren durchführen kann. Die Test-Zelle umfasst zwei Speicher, ein Flip-Flop und eine Latch-Zelle, um Testdaten zu speichern. Ein erster Multiplexer wählt aus mehreren Eingängen einen zur Verbindung mit dem Flip-Flop aus. Der Eingang der Latch-Zelle ist mit dem Ausgang des Flip-Flop verbunden. Der Ausgang der Latch-Zelle ist mit einem Eingang eines Multiplexers verbunden, während dem zweiten Eingang des Multiplexers ein Datensignal zugeführt wird. Ein Control-Bus steuert die Multiplexer, das Flip-Flop und die Latch-Zelle. Mittels einer solcher Test-Zelle können gleichzeitig Eingangssignale überwacht und Ausgangssignale gesteuert werden.

Aus der englischen Patentanmeldung GB 2 193 330 ist eine integrierte Logikschaltung bekannt, die eine Schaltung zum Testen umfasst. Die beschriebene Technik kann für ein Verfahren zum Testen von Teilen von integrierten Schaltungen genutzt werden. Dazu wird eine integrierte Logikschaltung in mehrere Teilblöcke, sogenannte 'combination circuits', aufgeteilt, die einzeln diagnostiziert werden. Ein Teilblock kann dabei jede Art von integrierter Schaltung sein, bei der das Ausgangssignal vom momentanen Eingangssignal abhängt (z.B. eine AND-, OR-, NOT- oder NAND-Schaltung). Über eine Latch-Zelle, die mit der Eingangsseite eines Teilblocks verbunden ist, wird dem Teilblock in Abhängigkeit von einem Steuerungssignal ein Testsignal zum Testen des Teilblocks oder ein Datensignal zugeführt. Dabei sind steuerbare Schalter vorgesehen, um zwischen dem Testsignal und dem Datensignal auszuwählen.

In der europäischen Patentanmeldung EP 0 136 461 wird eine mittels einer pegelempfindlichen Abfragekonstruktion testbare Verriegelungsschaltung (latch circuit) beschrieben, die in einem Systembereitschafts- und einem pegelempfindlichen Testmodus betrieben werden kann. Die Vorrichtung besitzt eine erste und eine zweite Gruppe mit jeweils drei Flip-Flops sowie eine Steuerungseinheit. Mittels der Steuerungseinheit kann die erste Gruppe von Flip-Flops während des Systembereitschaftsmodus als eine flankengesteuerte Verriegelungsschaltung vom D-Type selektiv angesteuert werden, und die erste und zweite Gruppe von Flip-Flops während des Testmodus als ein dreistufiges Schieberegister angesteuert werden.

Aufgabe der Erfindung ist es, eine integrierte Schaltung mit taktflankengesteuerten Registerstufen der eingangs genannten Art anzugeben, bei der die einzelnen Registerstufen einfach aufgebaut sind und schnell arbeiten und bei der dennoch ein einfacher und zuverlässiger Testbetrieb möglich ist.

Eine Lösung dieser Aufgabe ist erfindungsgemäß dadurch gekennzeichnet, daß jede Registerstufe eine Reihenschaltung einer taktflankengesteuerten Speicherstufe und einer taktpegelgesteuerten Speicherstufe mit je wenigstens einem Takteingang, einem Dateneingang und einem Ausgang enthält, und daß dem Dateneingang der ersten Speicherstufe der Reihenschaltung ein erster Multiplexer mit einem Auswahleingang, wenigstens zwei Dateneingängen und einem Datenausgang vorgeschaltet ist, wobei während des Testens der integrierten Schaltung die taktflankengesteuerten Speicherstufen der Registerstufen am Takteingang dasselbe erste Taktsignal und die taktpegelgesteuerten Speicherstufen der Registerstufen dasselbe zweite Taktsignal erhalten, wobei beide Taktsignale nicht überlappende Impulse aufweisen, und zum Einschreiben und Auslesen von Testsignalmustern der erste Multiplexer am Auswahleingang ein erstes Auswahlsignal erhält, um einen Dateneingang für Testsignale mit seinem Datenausgang zu verbinden, und wobei im normalen Betrieb dem Takteingang der taktpegelgesteuerten Speicherstufe der Registerstufen ständig ein erster Signalwert zugeführt wird, der diese Speicherstufe transparent schaltet.

Bei dieser Lösung wird der flankengesteuerten Speicherstufe, die für den Normalbetrieb verwendet wird, lediglich eine einfache taktpegelgesteuerte Speicherstufe in Reihe geschaltet, die im Normalbetrieb durch ein entsprechendes Signal am Takteingang einfach transparent geschaltet wird und somit praktisch nicht mehr wirksam wird, außer daß dadurch die Gesamtverzögerung in der Registerstufe geringfügig erhöht wird. Insbesondere wenn eine komplexe logische Schaltung mit CAE-Hilfsmitteln entworfen wird, wobei zunächst nur flankengesteuerte Speicherstufen verwendet werden, ist die Erweiterung eines solchen Entwurfs für Testzwecke leicht möglich.

Eine andere Lösung der genannten Aufgabe ist erfindungsgemäß dadurch gekennzeichnet, daß jede Registerstufe zwei in Reihe geschaltete taktpegelgesteuerte Speicherstufen mit je wenigstens einem Takteingang, einem Dateneingang und einem Ausgang enthält, daß dem Dateneingang der ersten Speicherstufe der Reihenschaltung ein erster Multiplexer mit einem Auswahleingang, wenigstens zwei Dateneingängen und einem Datenausgang vorgeschaltet ist und daß dem Takteingang der zweiten Speicherstufe ein zweiter Multiplexer mit einem Auswahleingang, wenigstens zwei Takteingängen und einem Taktausgang vorgeschaltet ist, wobei während des Testens der integrierten Schaltung die ersten Speicherstufen der Registerstufen am Takteingang dasselbe erste Taktsignal und die zweiten Multiplexer der Registerstufen an einem ersten Takteingang dasselbe zweite Taktsignal erhalten, wobei beide Taktsignale nicht überlappende Impulse aufweisen, und zum Einschreiben und Auslesen von Testsignalmustern der erste Multiplexer am Auswahleingang ein erstes Auswahlsignal erhält, um einen Dateneingang für Testsignale mit seinem Datenausgang zu verbinden, und der zweite Multiplexer am Auswahleingang ein zweites Auswahlsignal erhält, um den ersten Takteingang mit seinem Taktausgang zu verbinden, und wobei im normalen Betrieb der zweite Multiplexer an einem zweiten Takteingang das inverse erste Taktsignal und am Auswahleingang das inverse zweite Auswahlsignal erhält, um den zweiten Takteingang mit seinem Taktausgang zu verbinden.

Hier werden also zwei taktpegelgesteuerte Speicherstufen verwendet, die im Normalbetrieb mit zueinander inversen Taktsignalen angesteuert werden und damit wie eine flankengesteuerte Registerstufe reagieren. Im Testbetrieb werden die beiden Speicherstufen dagegen mit zwei getrennten Taktsignalen, die nicht überlappende Impulse aufweisen, gesteuert. Durch den zweiten Multiplexer vor dem Takteingang der zweiten Speicherstufe weist diese für das Taktsignal zwar eine andere Verzögerungszeit auf als die erste Speicherstufe, jedoch ist dieser Unterschied bei sorgfältiger Dimensionierung und Herstellung der Schaltung nicht schädlich.

Eine dritte Lösung der genannten Aufgabe ist erfindungsgemäß dadurch gekennzeichnet, daß jede Registerstufe zwei in Reihe geschaltete taktpegelgesteuerte Speicherstufen mit je wenigstens einem Takteingang, einem Dateneingang und einem Ausgang enthält, daß eine dritte derartige Speicherstufe vorgesehen ist, deren Dateneingang ein erster Multiplexer mit einem Auswahleingang, wenigstens zwei Dateneingängen und einem Datenausgang vorgeschaltet ist, von denen ein erster Dateneingang mit dem Dateneingang der ersten Speicherstufe verbunden ist, und daß ein zweiter Multiplexer vorgesehen ist, der einen Auswahleingang, zwei mit dem Ausgang der ersten bzw. der dritten Speicherstufe verbundene Dateneingänge und einen mit dem Dateneingang der zweiten Speicherstufe verbundenen Datenausgang aufweist, wobei während des Testens der integrierten Schaltung die zweiten Speicherstufen der Registerstufen am Takteingang dasselbe erste Taktsignal und die dritten Speicherstufen der Registerstufen am Takteingang dasselbe zweite Taktsignal erhalten, wobei beide Taktsignale nicht überlappende Impulse aufweisen, und zum Einschreiben und Auslesen von Testsignalmustern der erste und der dritte Multiplexer am Auswahleingang vorzugsweise ein gleiches erstes Auswahlsignal erhalten, um einen Dateneingang für Testsignale mit dem Dateneingang der dritten Speicherstufe bzw. den Ausgang der dritten Speicherstufe mit dem Dateneingang der zweiten Speicherstufe zu koppeln, und für das Einschreiben von Testergebnissen das erste Auswahlsignal wenigstens während der Dauer des Impulses des zweiten Taktsignals invertiert und wenigstens während der Dauer des Impulses des ersten Taktsignals nicht invertiert wird, und wobei im normalen Betrieb die erste Speicherstufe am Takteingang das inverse erste Taktsignal und der zweite Multiplexer das inverse Auswahlsignal erhält, um den Ausgang der ersten Speicherstufe mit dem Dateneingang der zweiten Speicherstufe zu koppeln.

Auch bei dieser Lösung werden zwei taktpegelgesteuerte Speicherstufen verwendet, die im Normalbetrieb mit zueinander inversen Taktsignalen angesteuert werden und sich damit wie eine flankengesteuerte Registerstufe verhalten. Zusätzlich wird eine dritte Speicherstufe verwendet, die nur für den Testbetrieb wirksam ist, und die dritte und zweite Speicherstufe erhalten Taktsignale mit nicht überlappenden Impulsen. Bei dieser Lösung ist anstelle des Taktmultiplexers ein Datenmultiplexer zwischen der ersten bzw. dritten Speicherstufe und der zweiten Speicherstufe eingesetzt.

Allen drei Lösungen ist jedoch gemeinsam, daß im Normalbetrieb die Registerstufen taktflankengesteuert arbeiten, während im Testbetrieb eine zuverlässige Zwei-Phasen-Steuerung erfolgt, wobei das im Normalbetrieb verwendete Taktsignal auch im Testbetrieb mit verwendet wird und damit auch mit geprüft wird. Durch die Zwei-PhasenSteuerung im Testbetrieb ist eine zuverlässige Schieberegistersteuerung auch bei Verwendung mehrerer Taktsysteme im Normalbetrieb möglich, und es sind auch keine Laufzeitprobleme bei interner Rückkopplung von Registerstufen über kombinatorische Teile möglich.

Ein besonders einfacher Aufbau der taktpegelgesteuerten Speicherstufen ist nach einer Ausgestaltung der Erfindung dadurch gekennzeichnet, daß jede taktpegelgesteuerte Speicherstufe die Reihenschaltung eines vierten Multiplexers, eines ersten und eines zweiten Inverters enthält, wobei der vierte Multiplexer zwei Eingänge, von denen der eine Eingang mit dem Ausgang des zweiten Inverters und der andere Eingang mit einem Dateneingang verbunden ist, einen Steuereingang, der mit einem Takteingang verbunden ist, und einen Ausgang aufweist, der mit dem Eingang des ersten Inverters verbunden ist. Eine derart aufgebaute Speicherstufe weist auch nur eine geringe Verzögerung auf, z.B. wenn diese durch ein entsprechendes Taktsignal ständig transparent geschaltet ist.

Ausführungsbeispiele der Erfindung werden nachstehend anhand der Zeichnung näher erläutert. Es zeigen
Fig. 1 schematisch der Aufbau einer integrierten Schaltung mit sequentieller Logik im Testbetrieb,
Fig. 2 und 3 zwei Möglichkeiten für die Reihenschaltung einer taktflankengesteuerten und einer taktpegelgesteuerten Speicherstufe,
Fig. 4 eine Registerstufe aus zwei taktpegelgesteuerten Speicherstufen mit Taktmultiplexer,
Fig. 5 eine Registerstufe mit drei taktpegelgesteuerten Speicherstufen und einem weiteren Datenmultiplexer,
Fig. 6 einige Impulsdiagramme für den Betrieb der dargestellten Speicherstufen,
Fig. 7 und 8 zwei Beispiele für den Aufbau einer taktpegelgesteuerten Speicherstufe.

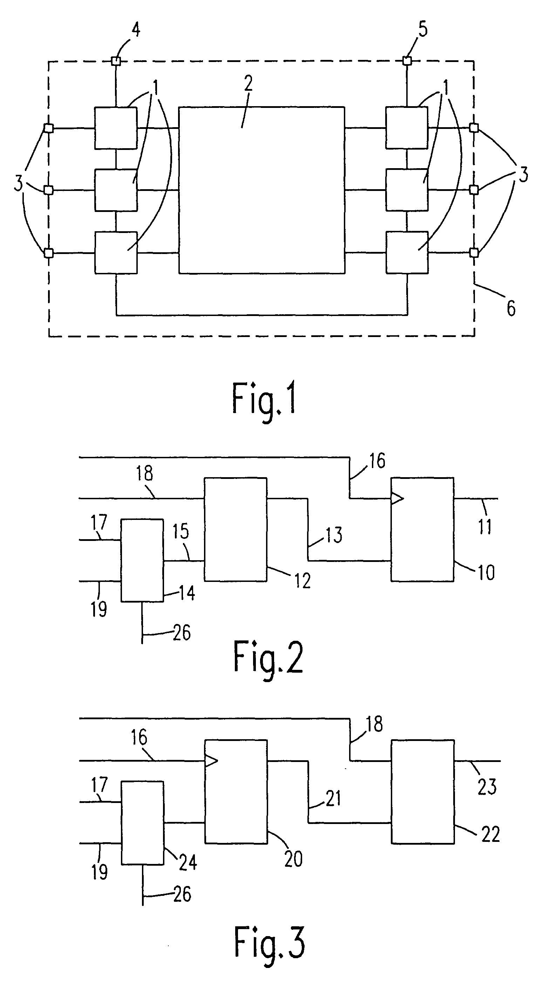

In Fig. 1 ist schematisch eine integrierte Schaltung 6 dargestellt, die eine sequentielle Logikschaltung enthält. Die speichernden Elemente dieser Schaltung sind als Registerstufen 1 angedeutet, die für den Testbetrieb als Schieberegister in Reihe geschaltet sind. Über einen Eingang 4 wird ein serielles Testmuster zugeführt, das mit Hilfe eines nicht dargestellten Taktsignals durch die Registerstufen 1 geschoben wird und an einem Ausgangsanschluß 5 wieder erscheint. Die mit den Registerstufen verbundenen kombinatorischen Teile der Logikschaltung sind hier vereinfacht als ein Block 2 dargestellt, der hier mit Ausgängen bzw. Eingängen der Registerstufen 1 verbunden ist. Für den Normalbetrieb sind Eingänge und Ausgänge der Registerstufen 1 außerdem über Anschlüsse 3 nach außen verbunden.

Im Testbetrieb wird zunächst ein Testmuster über den Eingangsanschluß 4 eingegeben und durch alle Registerstufen 1 geschoben, bis das Testmuster vollständig wieder am Ausgangsanschluß 5 erscheint, um zu prüfen, ob die Registerstufen 1 alle richtig arbeiten. Als nächstes wird ein Testmuster so eingeschrieben, daß alle Registerstufen 1 einen gewünschten Signalzustand aufweisen, der selbstverständlich für die einzelnen Registerstufen unterschiedlich sein kann, und danach werden die Ausgangssignale der kombinatorischen Teile 2 der Logikschaltung in die Registerstufen 1 durch eine entsprechende Steuerung übernommen, und dieses Ergebnis wird anschließend durch die Registerstufen 1 hindurchgeschoben und am Ausgangsanschluß 5 abgenommen und mit einem vorgegebenen Ergebnis verglichen. Für einen weitgehend vollständigen Test der integrierten Schaltung 6 müssen dann anschließend noch weitere, unterschiedliche Testmuster in die Registerstufen 1 eingeschrieben und die Ergebnisse jeweils wieder ausgelesen werden. Es ist jedoch auch möglich, zumindest einige der Ergebnis-Signalmuster als Testmuster für den nächsten Prüfschritt zu verwenden, um ein häufiges Durchschieben der Signalmuster durch die in Serie geschalteten Registerstufen 1 zu vermeiden. Auch andere Formen des Tests bzw. der Erzeugung und der Ausgabe der Testmuster, die jeweils die in Reihe als Schieberegister geschalteten Registerstufen verwenden, sind üblich.

Die Registerstufen 1 sind häufig als taktflankengesteuerte Registerstufen ausgeführt, die also mit einer bestimmten Flanke eines Taktimpulses, beispielsweise mit der positiven Flanke, ein beim Auftreten dieser Taktflanke an einem Dateneingang anliegendes Signal übernehmen und zum Ausgang durchschalten. Änderungen des Signals am Dateneingang vor und nach dieser Taktflanke bleiben ohne Einfluß. Bei dem in Fig. 1 dargestellten System ergeben sich jedoch Schwierigkeiten, wenn den einzelnen Registerstufen nicht dasselbe Taktsignal unmittelbar direkt zugeführt wird, sondern wenn im Normalbetrieb insbesondere verschiedene Taktsysteme verwendet werden und diese im Testbetrieb über zusätzliche Logikschaltungen zusammengeschaltet werden müssen. Ferner kann auch der Fall auftreten, daß eine Registerstufe, die einen kombinatorischen Teil der Logikschaltung speist, ein Ergebnissignal aus diesem oder einem anderen kombinatorischen Schaltungsteil aufnimmt und dabei ihren Signalzustand ändert und somit nun ein anderes Signal in den entsprechenden kombinatorischen Schaltungsteil einspeist. Wenn dieser Teil Einfluß auf das Eingangssignal einer anderen Registerstufe hat und diese durch logische Verknüpfungsglieder in der Taktleitung das Taktsignal verzögert erhält, kann diese andere Registerstufe dann ein falsches Ergebnis übernehmen. An die Registerstufen werden also insbesondere bezüglich der Umschaltung zwischen Testbetrieb und Normalbetrieb besondere Anforderungen gestellt.

Eine hierfür geeignete Registerstufe ist in Fig. 2 dargestellt. Diese besteht aus einer taktflankengesteuerten Speicherstufe 10, die in üblicher Weise aufgebaut sein kann, beispielsweise wie integrierte Flipflop-Schaltungen mit der Bezeichnung 74HC74. Eine derartige Speicherstufe weist einen Dateneingang, der mit einer Leitung 13 verbunden ist, einen Takteingang, der mit einer Taktleitung 16 verbunden ist, und wenigstens einen Ausgang auf, der mit einer Leitung 11 verbunden ist. Häufig sind aus solchen Speicherstufen auch komplementäre Ausgänge herausgeführt.

Der taktflankengesteuerten Speicherstufe 10 ist eine taktpegelgesteuerte Speicherstufe 12 vorgeschaltet, die ebenfalls einen Dateneingang, der mit einer Leitung 15 verbunden ist, einen Takteingang, der mit einer Leitung 18 verbunden ist, und einen mit der Leitung 13 verbundenen Ausgang aufweist. Eine solche Speicherstufe hat die Eigenschaft, daß beim einen Wert des Taktsignals auf der Leitung 18, beispielsweise beim hohen Signalwert, das Datensignal der Leitung 15 direkt zum Ausgang 13 hindurchgeleitet wird, wobei dieser Ausgang jeder Veränderung des Datensignals am Dateneingang folgt. Eine derartige Speicherstufe wird daher auch als "transparentes Latch" bezeichnet. Beim Übergang des Taktsignals auf den anderen Signalwert wird der momentan vorhandene Signalzustand festgehalten, und das Datensignal am Ausgang ist dann unabhängig von Signaländerungen am Dateneingang.

Der Speicherstufe 12 ist ferner ein Multiplexer 14 vorgeschaltet, der abhängig vom Signal an einem Auswahleingang, das über eine Leitung 26 zugeführt wird, das Signal an einem von zwei Dateneingängen 17 und 19 zum Ausgang 15 durchschaltet.

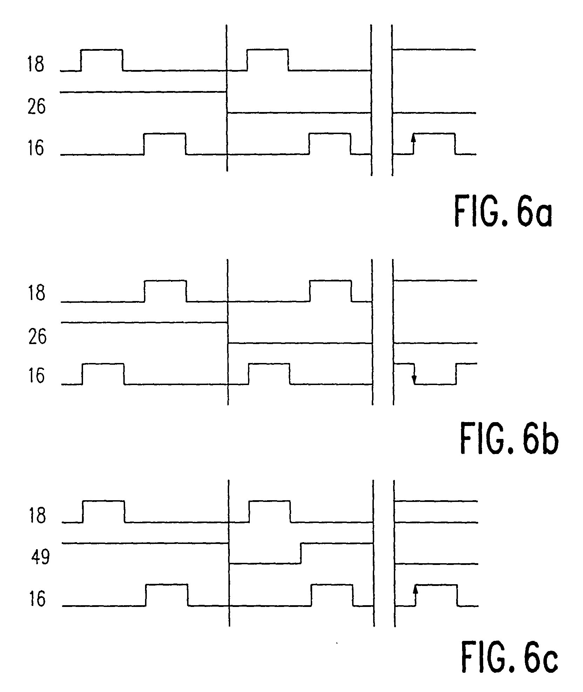

Der Betrieb einer solchen Registerstufe wird anhand des Diagramms in Fig. 6a näher erläutert. Darin sind drei verschiedene Abschnitte des Betriebs angegeben, wobei die drei Signalverläufe mit den Nummern der zugehörigen Leitung in Fig. 2 bezeichnet sind. Im ersten Abschnitt wird ein Testmuster in eine Kette von Registern, die in diesem Testbetrieb als Schieberegister in Reihe geschaltet sind, seriell eingeschrieben. Dazu erhält die Leitung 26 als Auswahlsignal für den Multiplexer 14 ein hohes Signal, wodurch der Dateneingang 19 mit dem Ausgang 15 verbunden ist. Dieser Dateneingang 19 ist mit dem Ausgang der vorhergehenden Registerstufe bzw. bei der ersten Registerstufe der Kette mit dem Anschluß 4 in Fig. 1 verbunden. Durch den ersten Impuls auf Taktleitung 18 wird das erste Bit in die Speicherstufe 12 eingeschrieben und dort gespeichert, bevor der erste Impuls auf der Taktleitung 16 erscheint, mit dessen Vorderflanke das Datensignal auf der Leitung 13 in die Speicherstufe 10 übernommen wird und am Ausgang 11 erscheint. Änderungen des Signals auf der Datenleitung 19 bzw. der damit gekoppelten Leitung 15 können sich zwischen dem Ende des Impulses auf der Leitung 18 und der Vorderflanke des Impulses auf der Leitung 16 nicht auswirken, so daß unterschiedliche Verzögerungen des Taktsignals auf der Leitung 16 zwischen verschiedenen Registerstufen völlig unschädlich sind. Da die beiden Taktsignale auf den Leitungen 16 und 18 von außerhalb der integrierten Schaltung zugeführt werden, kann der Abstand der Impulse nach Bedarf eingestellt werden.

Im zweiten Abschnitt in Fig. 6a sind die Abläufe bei der Übernahme eines Testergebnisses aus einem mit der Registerstufe verbundenen kombinatorischen Teil der Logikschaltung dargestellt. Zunächst erhält die Leitung 26 ein niedriges Signal, wodurch der Multiplexer 14 den Dateneingang 17, der mit dem Ausgang der kombinatorischen Teilschaltung verbunden ist, mit der Leitung 15 und damit mit dem Dateneingang der Speicherstufe 12 gekoppelt wird. Mit dem Impuls auf der Leitung 18 wird das Ausgangssignal der kombinatorischen Teilschaltung in die Speicherstufe 12 übernommen und erscheint auf der Leitung 13. Mit der Vorderflanke des nächsten Impulses auf der Leitung 16, die eine Zeitspanne nach dem Ende des Impulses auf der Leitung 18 erscheint, um unterschiedliche Signalverzögerungen zu berücksichtigen, wird das vorher von der kombinatorischen Teilschaltung erzeugte und in der Speicherstufe 12 zwischengespeicherte Ergebnis in die Speicherstufe 12 übernommen und erscheint am Ausgang 11. Dieses Ergebnis kann durch die Kette der Registerstufen zum Ausgang 5 in Fig. 1 geschoben werden, indem auf die Signalfolge im ersten Abschnitt in Fig. 6a wieder umgeschaltet wird.

Im letzten Abschnitt in Fig. 6a ist der Signalzustand im Normalbetrieb dargestellt, wo also das Signal auf der Leitung 18 ständig hoch ist, so daß die Speicherstufe 12 ständig transparent geschaltet ist, und das Signal auf der Leitung 26 ist ständig niedrig, so daß der normale Dateneingang 17 über den Multiplexer 14 und die Speicherstufe 12 mit der Leitung 13 gekoppelt ist.

Dadurch wird mit der Vorderflanke des Impulses auf der Taktleitung 16 direkt das Signal auf der Datenleitung 17 in die Speicherstufe 10 übernommen und erscheint sofort am Ausgang 11, d.h. die Registerstufe arbeitet wie gewünscht im Normalbetrieb als einfache taktflankengesteuerte Speicherstufe.

Wenn dagegen das Signal auf der Taktleitung 18 vorübergehend ständig niedrig gehalten wird, behält die Speicherstufe 12 den letzten Zustand auf der Datenleitung 17, und die Speicherstufe 10 hält diesen Zustand dann aufrecht und reagiert nicht mehr auf Signaländerungen auf der Datenleitung 17. Dies kann für einen leistungsarmen Ruhezustand von Bedeutung sein, da in der Registerstufe dann keine Signaländerungen mehr auftreten, so daß diese praktisch keine Leistung mehr verbraucht.

Die in Fig. 3 dargestellte Registerstufe weist einen ähnlichen Aufbau auf wie die in Fig. 2. Der Unterschied besteht im wesentlichen in der Vertauschung der beiden Speicherstufen, d.h. eine taktpegelgesteuerte Speicherstufe 22 ist einer taktflankengesteuerten Speicherstufe 20 nachgeschaltet. Der Aufbau der beiden Speicherstufen und des Multiplexers 24, der hier dem Dateneingang 25 der Speicherstufe 20 vorgeschaltet ist, kann mit dem Aufbau der entsprechenden Stufen in Fig. 2 übereinstimmen.

Durch die Vertauschung der Reihenfolge der beiden Speicherstufen ergibt sich auch eine etwas andere Ansteuerung, die in Fig. 6b dargestellt ist. Im Testbetrieb im ersten Abschnitt wird nach dem Zuführen eines neuen Bits eines Testmusters zunächst ein Impuls auf der Taktleitung 16 erzeugt, womit dieses Bit in die Speicherstufe 20 übernommen wird und auf der Leitung 21 erscheint. Währenddessen bleibt der vorhergehende Signalzustand am Ausgang 23 der Speicherstufe 22 noch stabil, so daß auch bei unterschiedlichen Verzögerungszeiten des Taktsignals auf der Leitung 16 für verschiedene Registerstufen untereinander keine Probleme auftreten. Erst eine ausreichende, maximale Verzögerungszeiten berücksichtigende Zeitspanne nach dem Taktimpuls auf der Leitung 16 erscheint ein Taktimpuls auf der Leitung 18, mit dem der Signalzustand auf der Leitung 21 zum Ausgang 23 durchgeschaltet wird. Die nun möglicherweise auftretenden Änderungen des Datensignals können sich auf den Zustand der Speicherstufe 20 und damit auf den Ausgang 23 nicht auswirken.

Bei der Übernahme eines Testergebnisses einer kombinatorischen Teilschaltung in eine Registerstufe treten die gleichen Vorgänge auf wie bei Fig. 2 erläutert, es muß lediglich nach dem Umschalten des Auswahlsignals auf der Leitung 26 für den Multiplexer 24 zunächst ein Impuls auf der Taktleitung 16 und dann erst ein Impuls auf der Taktleitung 18 auftreten.

Im Normalbetrieb ist wieder die Speicherstufe 22 durch ein hohes Signal auf der Taktleitung 18 ständig transparent geschaltet, so daß ein von der Speicherstufe 20 übernommenes Datensignal nicht nur auf der Leitung 21, sondern nach einer geringen Verzögerung durch die nun transparent geschaltete Speicherstufe 22 auch am Ausgang 23 erscheint.

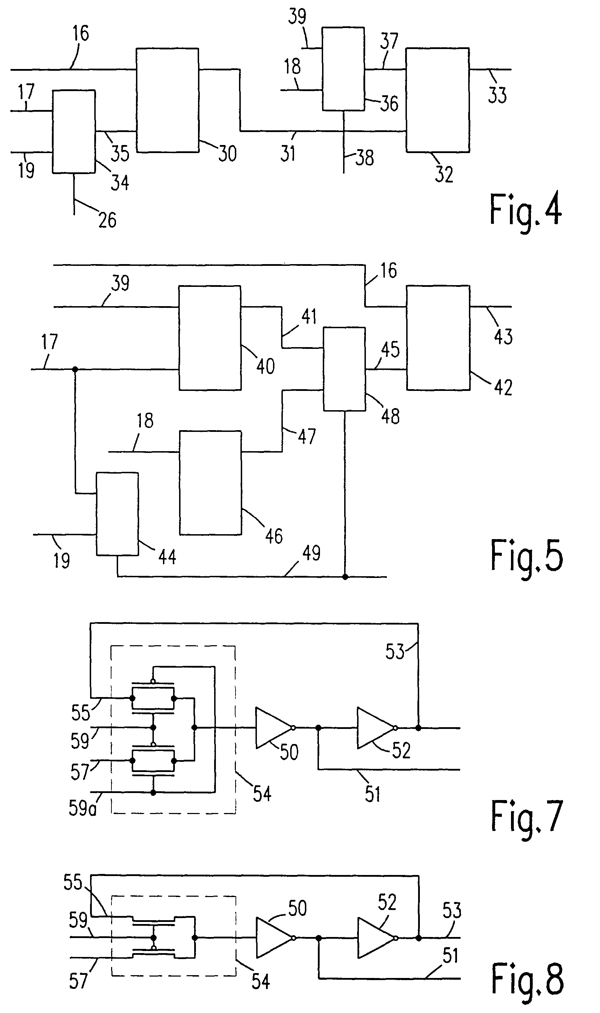

Die in Fig. 4 dargestellte Registerstufe enthält lediglich zwei taktpegelgesteuerte Speicherstufen 30 und 32, die bezüglich des Datensignals in Reihe geschaltet sind. Dem Dateneingang der ersten Speicherstufe 30 ist wieder ein Multiplexer 34 vorgeschaltet, der über ein Auswahlsignal auf der Leitung 26 einen ersten Dateneingang 17 oder einen zweiten Dateneingang 19 mit einer Leitung 35 koppelt, die auf den Dateneingang der Speicherstufe 30 führt. Dem Takteingang dieser Speicherstufe wird über die Leitung 16 ein Taktsignal zugeführt.

Der Ausgang der Speicherstufe 30 ist über die Leitung 31 mit dem Dateneingang der Speicherstufe 32 verbunden. Der Tatkeingang der Speicherstufe 32 ist über eine Leitung 37 mit dem Ausgang eines zweiten Multiplexers 36 verbunden, der abhängig von einer Auswahlsignal auf einer Leitung 38 am Auswahleingang einen mit einer Taktleitung 18 verbundenen Takteingang oder einen mit einer Leitung 39 verbundenen Takteingang mit der Leitung 37 koppelt.

Die Ansteuerung der Registerstufe in Fig. 4 erfolgt in gleicher Weise wie bei der Registerstufe nach Fig. 3, es muß lediglich über die Leitung 38 zusätzlich zwischen dem Testbetrieb und dem Normalbetrieb umgeschaltet werden.

Im Testbetrieb erhält die Leitung 38 ein derartiges Signal, daß der Multiplexer 36 die Taktleitung 18 mit dem Takteingang der Speicherstufe 32 koppelt. Zum Einschreiben eines Testmusters im Schieberegisterbetrieb erhält, wie im ersten Abschnitt in Fig. 6b dargestellt ist, die Leitung 26 ein hohes Signal, so daß die Leitung 19 mit dem Dateneingang der Speicherstufe 30 gekoppelt ist. Sobald auf der Taktleitung 16 ein Impuls auftritt, wird die Speicherstufe 30 transparent geschaltet, und das Datensignal auf der Leitung 19 erscheint nun auf der Leitung 31. Mit dem Ende des Impulses auf der Taktleitung 16 wird der Zustand der Speicherstufe 30 festgehalten, und danach wird mit dem Impuls auf der Leitung 18 die Speicherstufe 32 transparent geschaltet, so daß das übernommene Datensignal nun am Ausgang 33 erscheint. Irgendwelche Änderungen des Datensignals auf der Leitung 19 können sich bereits mit dem Ende des Impulses auf der Taktleitung 16 nicht mehr auswirken. Dadurch ist ein zuverlässiger Schieberegisterbetrieb möglich.

Zum Einschreiben eines Testergebnisses in die Registerstufe führt die Leitung 26 dem Auswahleingang des Multiplexers 34 ein niedriges Signal zu, so daß nunmehr die Datenleitung 17 über die Leitung 35 mit dem Dateneingang der Speicherstufe 30 gekoppelt ist. Mit dem nächsten Impuls auf der Taktleitung 16 wird das Signal auf der Datenleitung 17 in die Speicherstufe 30 übernommen, während am Ausgang 33 der Speicherstufe 32 der Signalzustand unverändert bleibt. Erst nach dem Ende des Impulses auf der Taktleitung 16 wird über die Taktleitung 18 ein Impuls zugeführt, der die Speicherstufe 32 transparent schaltet, so daß nun das von der Datenleitung 17 übernommene Signal am Ausgang 33 erscheint. Auch hier wirken sich Änderungen des Datensignal auf der Leitung 17 nach dem Ende des Impulses auf der Taktleitung 16 nicht mehr aus, so daß keine Laufzeitprobleme bei der Übernahme der Testergebnisse in die Registerstufen auftreten können.

Im Normalbetrieb erhält der Multiplexer 36 über die Leitung 38 am Auswahleingang ein derartiges Signal, daß der Takteingang 39 mit der Leitung 37 gekoppelt wird. Die Taktleitung 39 erhält die Invertierung der Taktimpulse auf der Taktleitung 16. Dadurch wird mit einem Impuls auf der Taktleitung 16 ein Datensignal in die Speicherstufe 30 übernommen, während mit der Rückflanke eines Impulses dieser Zustand der Speicherstufe 30 festgehalten und gleichzeitig die Speicherstufe 32 transparent geschaltet wird, so daß der festgehaltene Zustand der Speicherstufe 30 am Ausgang 33 erscheint. Damit verhält sich die Registerstufe nach Fig. 4 wie eine taktflankengesteuerte Speicherstufe, bei der allerdings die fallenden Flanken der Impulse auf der Taktleitung 16 wirksam sind. Dies ist jedoch eine weitgehend willkürliche Zuordnung, da die Impulse auf den Taktleitungen 16 und 39 invers zueinander sind und beispielsweise auch durch eine nicht dargestellte Inverterstufe innerhalb der Registerstufe erzeugt werden können.

Im Gegensatz zu der Registerstufe nach Fig. 3 ist bei der Registerstufe nach Fig. 4 der Signalzustand auf der Taktleitung 18 im Normalbetrieb nicht von Bedeutung, da durch den Multiplexer dann diese Taktleitung nicht mit einer Ausgangsleitung gekoppelt wird. Wenn jedoch im Normalbetrieb der Multiplexer 36 durch ein entsprechendes Auswahlsignal auf der Leitung 38 so geschaltet wird, daß die Taktleitung 18 mit der Leitung 37 gekoppelt wird und diese Taktleitung gleichzeitig ständig ein niedriges Signal führt, bleibt der Zustand der Registerstufe am Ausgang 33 erhalten, unabhängig von Signaländerungen auf Datenleitungen. Dies ist zweckmäßig, um eine zeitweisen Ruhezustand mit verringerter Verlustleistung der integrierten Schaltung einzustellen. Wenn andererseits bei dieser Einstellung des Multiplexers 36 beide Taktleitungen 16 und 18 ein hohes Signal haben, sind alle Speicherstufen 30 und 32 und damit alle Registerstufen transparent geschaltet, so daß auf diese Weise sehr schnell ein einheitlicher Anfangszustand aller Registerstufen eingestellt werden kann.

Die in Fig. 5 dargestellte Registerstufe verwendet drei taktpegelgesteuerte Speicherstufen 40, 42 und 46 sowie einen weiteren Datenmultiplexer 48 zwischen den Speicherstufen 40 bzw. 46 und 42, jedoch keinen Taktmultiplexer in einer der Taktleitungen. Der weitere Multiplexer 48 verbindet abhängig von einem Auswahlsignal auf einer Leitung 49 entweder den Ausgang der Speicherstufe 40 oder den Ausgang der Speicherstufe 46 über die Leitung 45 mit dem Dateneingang der Speicherstufe 42. Ein erster Multiplexer 44, der über das Auswahlsignal auf der Leitung 49 zwischen weiterzuschiebenden Testdaten oder von einer kombinatorischen Teilschaltung zu übernehmende Daten umgeschaltet wird, ist dem Dateneingang der Speicherstufe 46 vorgeschaltet. Der Betrieb der Registerstufe nach Fig. 5 soll anhand des Diagramms in Fig. 6c näher erläutert werden. Darin bezieht sich der erste Abschnitt wieder auf das Durchschieben eines Testmusters. Die Leitung 49 erhält ein hohes Signal, damit wird dem Dateneingang der Speicherstufe 46 das Datensignal der Leitung 19 zugeführt. Außerdem wird über den Multiplexer 48 der Ausgang dieser Speicherstufe 46 mit dem Dateneingang der Speicherstufe 42 gekoppelt. Mit einem Impuls auf der Taktleitung 18 wird das Datensignal auf der Datenleitung 19 in die Speicherstufe 46 übernommen und liegt dann über die Leitung 47, den Multiplexer 48 und die Leitung 45 am Dateneingang der Speicherstufe 42, die sich durch das niedrige Signal auf der Taktleitung 16 im Speicherzustand befindet und somit nicht auf Signale am Dateneingang reagiert. Mit dem Ende des Impulses auf der Taktleitung 18 geht die Speicherstufe 46 in ihren speichernden Zustand, und danach erscheint auf der Taktleitung 16 ein Impuls, womit die Speicherstufe 42 das vorher übernommene Datensignal zum Ausgang 43 weiterleitet. Bei einem entsprechenden Abstand der Impulse auf beiden Taktleitungen 16 und 18 ist dieser Vorgang unempfindlich gegenüber unterschiedlichen Signallaufzeiten der Taktsignale für verschiedene Registerstufen.

Zum Einschreiben des Testergebnisses einer mit der Datenleitung 17 verbundenen kombinatorischen Teilschaltung erhält die Leitung 49 zunächst ein niedriges Signal, wodurch die Datenleitung 17 mit dem Dateneingang der Speicherstufe 46 gekoppelt wird. Daß in diesem Zustand auch gleichzeitig der Ausgang 41 der Speicherstufe 40 mit dem Dateneingang der Speicherstufe 42 gekoppelt ist, ist nicht von Bedeutung, da durch das niedrige Signal auf der Taktleitung 16 während dieser Zeit die Speicherstufe 42 nicht auf Signale am Dateneingang reagiert. Mit dem nächsten Impuls auf der Leitung 18 wird das Datensignal auf der Leitung 17 in die Speicherstufe 46 eingeschrieben und mit dem Ende dieses Impulses dauerhaft gespeichert. Nun erhält die Leitung 49 wieder ein hohes Signal, so daß der Ausgang der Speicherstufe 46 über den Multiplexer 48 mit dem Dateneingang der Speicherstufe 42 gekoppelt ist, und dann erscheint ein Impuls auf der Taktleitung 16, so daß die Speicherstufe 42 das von der Datenleitung 17 übernommene Signal am Ausgang 43 abgibt. Es ist also ein Wechsel des Signals auf der Leitung 49 zwischen den beiden Impulsen auf den Taktleitungen 18 und 16 notwendig, der sich nur vermeiden ließe, wenn die beiden Multiplexer 44 und 48 mit getrennten Auswahlsignalen angesteuert würden. Dies erfordert jedoch eine zusätzliche Leitung in der integrierten Schaltung, die einen merklichen Aufwand darstellt.

Im Normalbetrieb erhält die Leitung 49 ständig ein niedriges Signal, so daß ständig der Ausgang der Speicherstufe 40 über die Leitung 41, den Multiplexer 48 und die Leitung 45 mit dem Dateneingang der Speicherstufe 42 verbunden ist. Die Speicherstufe 40 erhält am Dateneingang das Datensignal der Leitung 17, und der Takteingang ist mit der Taktleitung 39 verbunden, die ein zu der Leitung 16 inverses Signal führt. Damit arbeitet die Registerstufe nach Fig. 5 im Normalbetrieb in entsprechender Weise wie die Registerstufe nach Fig. 4. Auch mit der Registerstufe nach Fig. 5 läßt sich ein verlustleistungsarmer Betrieb einstellen, wenn die Leitung 49 ein hohes Signal erhält und die Taktleitung 18 einen einzelnen Impuls, mit dem das Datensignal auf der Leitung 17 in die Speicherstufe 46 übernommen wird. Wenn nun das Signal auf der Leitung 18 dauernd niedrig gehalten wird, reagieren die Speicherstufen 46 und 42 nicht mehr auf Signaländerungen auf der Datenleitung 17, so daß die Verlustleistung niedrig gehalten wird und der letzte bedeutsame Zustand der Datenleitung 17 am Ausgang 43 aufrechterhalten wird. Andererseits ist, wenn bei diesem hohen Signalpegel auf der Leitung 49 beide Taktleitungen 16 und 18 ein hohes Signal führen, eine sehr schnelle Einstellung aller in Reihe geschalteter Registerstufen auf einen einheitlichen wählbaren Signalzustand möglich.

Allen beschriebenen Ausführungen der Registerstufe ist gemeinsam, daß diese sowohl als taktflankengesteuerte Registerstufe als auch als zweiphasengesteuerte Registerstufe betrieben werden kann, wobei nur eine zusätzliche Taktleitung notwendig ist. Die im normalen Betrieb verwendete Taktleitung wird auch als zweiter Phasentakt im Testbetrieb verwendet und wird damit auch gleichzeitig getestet. Im Normalbetrieb erfolgt der Betrieb der Registerstufen nur flankengesteuert, so daß eine hohe Verarbeitungsgeschwindigkeit möglich ist, während der langsamere Zweiphasenbetrieb nur im Testfall wirksam ist.

Die in den Registerstufen verwendeten taktpegelgesteuerten Speicherstufen können auf verschiedene Weise aufgebaut sein. Ein besonders einfacher Aufbau ist beispielsweise in Fig. 7 dargestellt. Dieser besteht aus zwei in Reihe geschalteten Inverterstufen 50 und 52 mit üblichem Aufbau sowie einem Multiplexer 54 mit zwei Dateneingängen 55 und 57 sowie zwei Steuereingängen 59 und 59a, die zueinander komplementäre Signale erhalten. Im Betrieb als Speicherstufe werden die Steuersignale durch Taktsignale gebildet.

Der Multiplexer 54 enthält zwei Zweige mit je einem N-Kanal-Transistor und einem P-Kanal-Transistor, der durch einen Punkt an seinem Gate gekennzeichnet ist. In der einen Stellung des Multiplexers 54, wenn am Steuereingang 59 ein hohes Signal und am Steuereingang 59a ein niedriges Signal liegt, ist der Eingang 55 mit dem Ausgang verbunden, der auf den Eingang des Inverters 50 führt, so daß ein geschlossener Ring entsteht, der speichernde Eigenschaften hat. Die Leitungen 51 und 53 liefern je zueinander inverse Ausgangssignale der Speicherstufe.

In der anderen Stellung des Multiplexers 54, wenn die Leitung 59 ein niedriges Signal und die Leitung 59a ein hohes Signal empfängt, ist kein geschlossener Ring mehr vorhanden, sondern der Dateneingang 57 ist mit dem Eingang des Inverters 50 verbunden, so daß nunmehr die Signale auf den Leitungen 51 und 53 dem Signalzustand am Eingang 57 folgen.

Wenn die Inverter 50 und 52 ebenfalls in komplementärer MOS-Transistor-Technik ausgeführt sind, entsteht in der Schaltung nach Fig. 7 nur beim Umschalten eine gewisse Verlustleistung, nicht jedoch bei konstanten Signalen. Die Fig. 8 zeigt dagegen eine Ausführung einer taktpegelgesteuerten Speicherstufe mit Invertern 50 und 52, die beispielsweise nur mit N-Kanal-Transistoren aufgebaut sind und auch im Ruhezustand einen gewissen Strom führen, jedoch ist hier der Multiplexer 54 einfacher aufgebaut und enthält im einen Zweig nur einen N-Kanal-Transistor und im anderen Zweig nur einen P-Kanal-Transistor. Dadurch ist nur ein Steuereingang 59 notwendig. Bei einem hohen Signal an diesem Steuereingang ist der Eingang 55 des Multiplexers 54 mit dem Inverter 50 gekoppelt, womit wieder der Speicherzustand eingestellt ist, während bei einem niedrigen Signal am Steuereingang 59 der Eingang 57 des Multiplexers 54 mit dem Inverter 50 gekoppelt ist, wodurch also das Datensignal am Eingang 57 übernommen wird.

## Patentansprüche

1. Integrierte Schaltung mit mehreren taktgesteuerten Registerstufen, von denen jede wenigstens einen Takteingang, einen Dateneingang und einen Ausgang aufweist und bei der einen Flanke von dem Takteingang zugeführten Impulsen ein dem Dateneingang zugeführtes Signal speichert und am Ausgang abgibt,
**dadurch gekennzeichnet, daß** jede Registerstufe eine Reihenschaltung einer taktflankengesteuerten Speicherstufe (10, 20) und einer taktpegelgesteuerten Speicherstufe (12, 22) mit je wenigstens einem Takteingang, einem Dateneingang und einem Ausgang enthält, und daß dem Dateneingang der ersten Speicherstufe (12, 20) der Reihenschaltung ein erster Multiplexer (14, 24) mit einem Auswahleingang, wenigstens zwei Dateneingängen und einem Datenausgang vorgeschaltet ist, wobei während des Testens der integrierten Schaltung die taktflankengesteuerten Speicherstufen (10, 20) der Registerstufen am Takteingang dasselbe erste Taktsignal und die taktpegelgesteuerten Speicherstufen (12, 22) der Registerstufen dasselbe zweite Taktsignal erhalten, wobei beide Taktsignale nicht überlappende Impulse aufweisen, und zum Einschreiben und Auslesen von Testsignalmustern der erste Multiplexer (14, 24) am Auswahleingang ein erstes Auswahlsignal erhält, um einen Dateneingang für Testsignale mit seinem Datenausgang zu verbinden, und wobei im normalen Betrieb dem Takteingang der taktpegelgesteuerten Speicherstufe (12, 22) der Registerstufen ständig ein erster Signalwert zugeführt wird, der diese Speicherstufe transparent schaltet.

2. Integrierte Schaltung mit mehreren taktgesteuerten Registerstufen, von denen jede wenigstens einen Takteingang, einen Dateneingang und einen Ausgang aufweist und bei der einen Flanke von dem Takteingang zugeführten Impulsen ein dem Dateneingang zugeführtes Signal speichert und am Ausgang abgibt,
**dadurch gekennzeichnet, daß** jede Registerstufe zwei in Reihe geschaltete taktpegelgesteuerte Speicherstufen (30, 32) mit je wenigstens einem Takteingang, einem Dateneingang und einem Ausgang enthält, daß dem Dateneingang der ersten Speicherstufe (30) der Reihenschaltung ein erster Multiplexer (34) mit einem Auswahleingang, wenigstens zwei Dateneingängen und einem Datenausgang vorgeschaltet ist und daß dem Takteingang der zweiten Speicherstufe (32) ein zweiter Multiplexer (36) mit einem Auswahleingang, wenigstens zwei Takteingängen und einem Taktausgang vorgeschaltet ist, wobei während des Testens der integrierten Schaltung die ersten Speicherstufen der Registerstufen am Takteingang dasselbe erste Taktsignal und die zweiten Multiplexer der Registerstufen an einem ersten Takteingang dasselbe zweite Taktsignal erhalten, wobei beide Taktsignale nicht überlappende Impulse aufweisen, und zum Einschreiben und Auslesen von Testsignalmustern der erste Multiplexer (34) am Auswahleingang ein erstes Auswahlsignal erhält, um einen Dateneingang für Testsignale mit seinem Datenausgang zu verbinden, und der zweite Multiplexer am Auswahleingang ein zweites Auswahlsignal erhält, um den ersten Takteingang mit seinem Taktausgang zu verbinden, und wobei im normalen Betrieb der zweite Multiplexer an einem zweiten Takteingang das inverse erste Taktsignal und am Auswahleingang das inverse zweite Auswahlsignal erhält, um den zweiten Takteingang mit seinem Taktausgang zu verbinden.

3. Integrierte Schaltung mit mehreren taktgesteuerten Registerstufen, von denen jede wenigstens einen Takteingang, einen Dateneingang und einen Ausgang aufweist und bei der einen Flanke von dem Takteingang zugeführten Impulsen ein dem Dateneingang zugeführtes Signal speichert und am Ausgang abgibt,
**dadurch gekennzeichnet, daß** jede Registerstufe zwei in Reihe geschaltete taktpegelgesteuerte Speicherstufen (40, 42) mit je wenigstens einem Takteingang, einem Dateneingang und einem Ausgang enthält, daß eine dritte derartige Speicherstufe (46) vorgesehen ist, deren Dateneingang ein erster Multiplexer (44) mit einem Auswahleingang, wenigstens zwei Dateneingängen und einem Datenausgang vorgeschaltet ist, von denen ein erster Dateneingang mit dem Dateneingang der ersten Speicherstufe (40) verbunden ist, und daß ein zweiter Multiplexer (48) vorgesehen ist, der einen Auswahleingang, zwei mit dem Ausgang der ersten bzw. der dritten Speicherstufe (40, 46) verbundene Dateneingänge und einen mit dem Dateneingang der zweiten Speicherstufe (42) verbundenen Datenausgang aufweist, wobei während des Testens der integrierten Schaltung die zweiten Speicherstufen (42) der Registerstufen am Takteingang dasselbe erste Taktsignal und die dritten Speicherstufen (46) der Registerstufen am Takteingang dasselbe zweite Taktsignal erhalten, wobei beide Taktsignale nicht überlappende Impulse aufweisen, und zum Einschreiben und Auslesen von Testsignalmustern der erste und der dritte Multiplexer (44, 48) am Auswahleingang vorzugsweise ein gleiches erstes Auswahlsignal erhalten, um einen Dateneingang für Testsignale mit dem Dateneingang der dritten Speicherstufe (46) bzw. den Ausgang der dritten Speicherstufe mit dem Dateneingang der zweiten Speicherstufe (42) zu koppeln, und für das Einschreiben von Testergebnissen das erste Auswahlsignal wenigstens während der Dauer des Impulses des zweiten Taktsignals invertiert und wenigstens während der Dauer des Impulses des ersten Taktsignals nicht invertiert wird, und wobei im normalen Betrieb die erste Speicherstufe (40) am Takteingang das inverse erste Taktsignal und der zweite Multiplexer (48) das inverse Auswahlsignal erhält, um den Ausgang der ersten Speicherstufe (40) mit dem Dateneingang der zweiten Speicherstufe (42) zu koppeln.

4. Integrierte Schaltung nach einem der Ansprüche 1 bis 3,
**dadurch gekennzeichnet, daß** jede taktpegelgesteuerte Speicherstufe (12, 22, 30, 32, 40, 42, 46) die Reihenschaltung eines vierten Multiplexers (54), eines ersten und eines zweiten Inverters (50, 52) enthält, wobei der vierte Multiplexer (54) zwei Eingänge (55, 57), von denen der eine Eingang (55) mit dem Ausgang (53) des zweiten Inverters (52) und der andere Eingang (57) mit einem Dateneingang verbunden ist, einen Steuereingang (59, 59a), der mit einem Takteingang verbunden ist, und einen Ausgang aufweist, der mit dem Eingang des ersten Inverters (50) verbunden ist.

## Claims

1. An integrated circuit having a plurality of clocked register stages each having at least a clock input, a data input and an output, an edge of pulses applied to the clock input causing a signal applied to the data input to be stored and to be supplied to the output,
**characterized in that** each register stage includes a series arrangement of an edge-clocked memory stage (10, 20) and a level-clocked memory stage (12, 22), each having at least one clock input, a data input and an output, and **in that** the data input of the first memory stage (12, 20) of the series arrangement is preceded by a first multiplexer (14, 24) having a select input, at least two data inputs and a data output, wherein during testing of the integrated circuit the edge-clocked memory stages (10, 20) of the register stages receive the same first clock signal on the clock input, and the level-clocked memory stages (12, 22) of the register stages receive the same second clock signal, both clock signals having non-overlapping pulses, and for loading and reading-out test signal patterns the first multiplexer (14, 24) receives a first select signal on its select input in order to connect a data input for test signals to its data output, and wherein in normal operation constantly a first signal value is applied to the clock input of the level-clocked memory stage (12, 22) of the register stages, which switches this memory stage to transparent operation.

2. An integrated circuit having a plurality of clocked register stages each having at least one clock input, a data input and an output, an edge of pulses applied to the clock input causing a signal applied to the data input to be stored and to be supplied to the output,
**characterized in that** each register stage includes two series-connected level-clocked memory stages (30, 32) each having at least one clock input, a data input and an output, **in that** the data input of the first memory stage (30) of the series arrangement is preceded by a first multiplexer (34) having a select input, at least two data inputs and a data output, and **in that** the clock input of the second memory stage (32) is preceded by a second multiplexer (36) having a select input, at least two data inputs and a data output, wherein during testing of the integrated circuit the first memory stages of the register stages receive the same first clock signal on their clock inputs, and the second multiplexers of the register stages receive the same second clock signal on a first clock input, both clock signals having non-overlapping pulses, and for loading and reading-out test signal patterns the first multiplexer (34) receives a first select signal on its select input in order to connect a data input for test signals to its data output, and the second multiplexer receives a second select signal on its select input in order to connect the first clock input to its clock output, and wherein in normal operation the second multiplexer receives the inverse first clock signal on a second clock input and the inverse second select signal on its select input in order to connect the second clock input to its clock output.

3. An integrated circuit having a plurality of clocked register stages each having at least one clock input, a data input and an output, an edge of pulses applied to the clock input causing a signal applied to the data input to be stored and to be supplied to the output,
**characterized in that** each register stage comprises two series-connected level-clocked memory stages (40, 42) each having at least one clock input, a data input and an output, **in that** there has been provided a third similar memory stage (46) whose data input is preceded by a first multiplexer (44) having a select input, at least two data inputs and a data output, of which a first data input is connected to the data input of the first memory stage (40), and **in that** there has been provided a second multiplexer (48) having a select input, two data inputs connected to the output of the first and the third memory stage (40, 46), respectively, and a data output connected to the data input of the second memory stage (42), wherein during testing of the integrated circuit the second memory stages (42) of the register stages receive the same first clock signal on the clock input and the third memory stages (46) of the register stages receive the same second clock signal on the clock input, both clock signals having non-overlapping pulses, and for loading and reading-out test signal patterns the first and the third multiplexer (44, 48) preferably receive a similar first select signal on the select input in order to couple a data input for test signals to the data input of the third memory stage (46), and to couple the output of the third memory stage to the data input of the second memory stage (42), and for loading test results the first select signal is inverted at least for the pulse duration of the second clock signal and is not inverted at least for the pulse duration of the first clock signal, and wherein in normal operation the first memory stage (40) receives the inverse first clock signal on its clock input and the second multiplexer (48) receives the inverse select signal, in order to couple the output of the first memory stage (40) to the data input of the second memory stage (42).

4. An integrated circuit as claimed in any one of the Claims 1 to 3,
**characterized in that** each level-clocked memory stage (12, 22, 30, 32, 40, 42, 46) includes the series arrangement of a fourth multiplexer (54), a first and a second inverter (50, 52), the fourth multiplexer (54) having two inputs (55, 57), one input (55) being connected to the output (53) of the second inverter (52) and the other input (57) to a data input, a control input (59, 59a) connected to a clock input, and an output connected to the input of the first inverter(50).

## Revendications

1. Circuit intégré avec plusieurs étages de registres commandés par rythme dont chacun présente au moins une entrée de rythme, une entrée de données et une sortie et enregistre un signal amené à l'entrée de données et le délivre à la sortie à l'un des flancs des impulsions amenées par l'entrée de rythme,
**caractérisé en ce que** chaque étage de registre contient un montage en série d'un étage de mémorisation (10, 20) commandé par flancs de rythme et d'un étage de mémorisation (12, 22) commandé par niveau de rythme avec respectivement au moins une entrée de rythme, une entrée de données et une sortie et qu'à l'entrée de données du premier étage de mémorisation (12, 20) du montage en série, un premier multiplexeur (14, 24) avec une entrée de sélection est monté en amont d'au moins deux entrées de données et une sortie de données tandis que, pendant le test du circuit intégré, les étages de mémorisation (10, 20) commandés par flanc de rythme des étages de registres à l'entrée de rythme reçoivent le même premier signal de rythme et les étages de mémorisation (12, 22) commandés par niveau de rythme des étages de registres reçoivent le même deuxième signal de rythme, les deux signaux de rythme ne présentant pas des impulsions qui se chevauchent et, en vue de l'enregistrement et de la lecture des modèles du signal de test, le premier multiplexeur (14, 24) reçoit à l'entrée de sélection un premier signal de sélection pour relier une entrée de données pour les signaux de test avec sa sortie de données et, en mode normal, une valeur de signal qui monte de manière transparente cet étage de mémorisation est amenée en permanence à l'entrée de rythme de l'étage de mémorisation (12, 22) commandé par niveau de rythme des étages de registres.

2. Circuit intégré avec plusieurs étages de registres commandés par rythme dont chacun présente au moins une entrée de rythme, une entrée de données et une sortie et mémorise un signal amené à l'entrée de données et le délivre à la sortie à un flanc des impulsions amenées à l'entrée de données,
**caractérisé en ce que** chaque étage de registre contient deux étages de mémorisation (30, 32) commandés par niveau de rythme et montés en série avec respectivement au moins une entrée de rythme, une entrée de données et une sortie, qu'en amont de l'entrée de données du premier étage de mémorisation (30) du circuit en série, est monté un premier multiplexeur (34) avec une entrée de sélection, au moins deux entrées de données et une sortie de données et qu'en amont de l'entrée de rythme du deuxième étage de mémorisation (32) est monté un deuxième multiplexeur (36) avec une entrée de sélection, au moins deux entrées de rythme et une sortie de rythme, tandis que, pendant le test du circuit intégré, les premiers étages de mémorisation des étages de registres reçoivent à l'entrée de rythme le même premier signal de rythme et les deuxièmes multiplexeurs des étages de registres reçoivent à une première entrée de rythme le même deuxième signal de rythme, les deux signaux de rythme ne présentant pas des impulsions chevauchantes et, en vue de l'enregistrement de la lecture de modèles de signaux de test, le premier multiplexeur (34) reçoit à l'entrée de sélection un premier signal de sélection pour relier une entrée de données pour des signaux de test avec sa sortie de données et le deuxième multiplexeur reçoit à l'entrée de sélection un deuxième signal de sélection pour relier la première entrée de rythme avec sa sortie de rythme et, en mode normal, le deuxième multiplexeur reçoit à une deuxième entrée de rythme le premier signal de rythme inverse et, à l'entrée de sélection, le deuxième signal de sélection inverse pour relier la deuxième entrée de rythme à sa sortie de rythme.

3. Circuit intégré avec plusieurs étages de registres commandés par rythme dont chacun présente au moins une entrée de rythme, une entrée de données et une sortie et qui mémorise un signal amené à l'entrée de données et le délivre à la sortie à un flanc des impulsions amenées à l'entrée de rythme,
**caractérisé en ce que** chaque étage de registre contient deux étages de mémorisation (40, 42) commandés par niveau de rythme et montés en série avec respectivement au moins une entrée de rythme, une entrée de données et une sortie, qu'il est prévu un troisième étage de mémorisation (46) de ce type en amont de l'entrée de données duquel est monté un premier multiplexeur (44) avec une entrée de sélection, au moins deux entrées de données et une sortie de données, dont une première entrée de données est reliée à l'entrée de données du premier étage de mémorisation (40) et qu'il est prévu un deuxième multiplexeur (48) qui présente une entrée de sélection, deux entrées de données reliées à la sortie des premier ou troisième étages de mémorisation (40, 46) et une sortie de données reliée à l'entrée de données du deuxième étage de mémorisation (42) tandis que, pendant le test du circuit intégré, les deuxièmes étages de mémorisation (42) des étages de registres reçoivent à l'entrée de rythme le même premier signal de rythme et les troisièmes étages de mémorisation (46) des étages de registres reçoivent à une première entrée de rythme le même deuxième signal de rythme, les deux signaux de rythme ne présentant pas des impulsions qui se chevauchent et, en vue de l'enregistrement et de la lecture de modèles de signaux de test, le premier et le troisième multiplexeurs (44, 48) reçoivent de préférence à l'entrée de sélection un premier signal de sélection identique pour relier une entrée de données pour des signaux de test avec la sortie de données du troisième étage de mémorisation (46) ou la sortie du troisième étage de mémorisation avec l'entrée de données du deuxième étage de mémorisation (42) et, pour l'enregistrement des résultats du test, le premier signal de sélection est inversé au moins pendant la durée de l'impulsion du deuxième signal de rythme et n'est pas inversé au moins pendant la durée de l'impulsion du premier signal de rythme et, en mode normal, le premier étage de mémorisation (40) reçoit à l'entrée de rythme le premier signal de rythme inversé et le deuxième multiplexeur (48) reçoit le signal de sélection inverse pour coupler la sortie du premier étage de mémorisation (40) avec l'entrée de données du deuxième étage de mémorisation (42).

4. Circuit intégré, selon l'une des revendications 1 à 3,
**caractérisé en ce que** chaque étage de mémorisation (12, 22, 30, 32, 40, 42, 46) commandé par niveau de rythme contient le montage en série d'un quatrième multiplexeur (54), d'un premier et d'un deuxième inverseurs (50, 52), le quatrième multiplexeur (54) présentant deux entrées (55, 57) dont l'une des entrées (55) est reliée à la sortie (53) du deuxième inverseur (52) et l'autre entrée (57) est reliée à une entrée de données, une entrée de commande (59, 59a) qui est reliée à une entrée de rythme et une sortie qui est reliée à l'entrée du premier inverseur (50).
